(19) Europäisches Patentamt
European Patent Office
Office européen des brevets

(11) **EP 4 310 056 A1**

(12) **EUROPEAN PATENT APPLICATION**

(43) Date of publication:
**24.01.2024 Bulletin 2024/04**

(21) Application number: **23185366.4**

(22) Date of filing: **13.07.2023**

(51) International Patent Classification (IPC):
*C01G 53/00* (2006.01)   *H01M 4/525* (2010.01)
*H01M 10/054* (2010.01)

(52) Cooperative Patent Classification (CPC):
**C01G 53/50; H01M 4/525; H01M 10/054;**
C01P 2002/72; C01P 2004/03; C01P 2004/61;
C01P 2006/11; C01P 2006/12; C01P 2006/40;
Y02E 60/10

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **18.07.2022   CN 202210841843**

(71) Applicant: **Guizhou Zhenhua E-CHEM Inc.
Guiyang City, Guizhou 550014 (CN)**

(72) Inventors:
• **ZHOU, Chaoyi
Guiyang City, 550014 (CN)**

• **XIANG, Qianxin
Guiyang City, 550014 (CN)**
• **WANG, Lijuan
Guiyang City, 550014 (CN)**
• **HUANG, Jin
Guiyang City, 550014 (CN)**
• **YU, Ye
Guiyang City, 550014 (CN)**

(74) Representative: **Dehns
St. Bride's House
10 Salisbury Square
London EC4Y 8JD (GB)**

(54) **A MONO-CRYSTALLINE CATHODE MATERIAL FOR SODIUM-ION BATTERY AND PREPARATION METHOD AND APPLICATION THEREOF**

(57)   The present invention relates to a mono-crystalline cathode material for sodium-ion battery and a preparation method and application thereof. The mono-crystalline cathode material for a sodium ion battery contains the chemical formula of $Na_{1+a}Ni_{1-x-y-z-c}Mn_xFe_yM_zN_cO_2$, wherein - $0.40 \leq a \leq 0.25$, $0.08 \leq x \leq 0.5$, $0.05 \leq y \leq 0.5$, $0 \leq z < 0.26$, $0 < c < 0.1$, the M and N are both one or a combination of two or more selected from the group consisting of Ti, Zn, Co, Mn, Al, Zr, Y, Ca, Li, Rb, Cs, W, Ce, Mo, Ba, Mg, Ta, Nb, V, Sc, Sr, B, F, P or Cu elements. The mono-crystalline cathode material for sodium-ion battery has a specific chemical composition, has a mono crystal morphology, and good structural stability and integrity. Particle fragmentation can not be produced in the cyclic process, and meanwhile, the cyclic stability of the sodium-ion battery can be improved.

EP 4 310 056 A1

## Description

### Technical Field

The present invention related to the technical field of sodium ion batteries, and particularly relates to a mono-crystalline cathode material for sodium-ion battery and preparation method and application thereof.

### Background Art

With the compition of lithium ion batteries becoming increasingly fierce, coupled with the supply and demand relationship, and the limitation of resources and land resources, the price of lithium salt is rapidly rising, so that the sodium-ion battery with cost advantage has gradually become a research hotspot in large enterprises and universities. The working principle of sodium ion battery is the same as that of lithium ion battery, but compared with that of lithium ion battery, the ionic radius of sodium ion is larger and the diffusion kinetics is slower, so that sodium ion has certain disadvantages in energy density and cycle performance.

After nearly ten years of extensive research, sodium-ion batteries have formed products mainly based on transition metal oxides, prussian blue, polyanionic phosphate and other systems and other products, in which transition metal oxides with relatively high specific capacity, have been favored, but poor cycle performance and low energy density have been an important factor affecting the use of cathode materials for sodium ion batteries.

At present, there are two kinds of transition metal oxides on the market, one is a nickel-manganese-iron-copper-based oxide containing copper element, and the other is a nickel-iron-manganese-based oxide. Regardless of any one of the two, changing the different ratios of nickel, iron, manganese and copper elements leads to cathode materials for sodium ion batteries with different properties. The stability of the material in contact with the electrolyte also changes due to the different ratios of the elements. However, the factors influencing the cycle life of the cathode materials for a sodium ion battery include: 1. reconstitution of surface crystal structure during cycling; and 2. agglomerated particles breaking up during cycling due to anisotropic volume expansion. The results show that the local current density increases due to the connection structure between particles and particles, which results in great stress and affects the cycle performance of the materials. At the same time, there is a state of charge inconsistency between various parts inside the particles, which affects the electrochemical performance of the electrode.

In addition, when the amount of sodium removal from the cathode material of a sodium ion battery is large, the structure becomes very fragile, the active metal and oxygen in the crystal lattice shift, reaching a certain high temperature and high pressure, the atomic rearrangement and reconstruction gradually intensifies, and the grain volume and phase change greatly. On the other hand, when the cathode material is desalted, its oxidation property is enhanced, and it is very easy to have chemical and electrochemical interaction with the electrolyte, resulting in easy deoxidation of the material, and dissolution of transition metals. Particularly under high voltage, the electrolyte will be oxidized to generate $H^+$, which increases the acidity of the electrolyte, thus the surface film of the electrode material is damaged by HF, and the composition and structure of the interface are further changed, seriously affecting the electrochemical performance and cycle performance of the material.

### Summary of the Invention

The technical problem to be solved by the present invention is that a mono-crystalline cathode material for sodium-ion battery is provided to improve the cycle performance of the sodium-ion battery.

In view of the above-mentioned technical problems, the inventors of the present application have intensively studied to obtain a mono-crystalline cathode material for sodium-ion battery with a mono crystal morphology. Using surface coating or performing body phase doping and surface coating modification at the same time can effectively avoid direct contact between the material and an electrolyte, especially HF in the electrolyte, thereby preventing the occurrence of side reactions, inhibiting the crystal phase transition of the material, and improving the cycling stability of the material. Application to a sodium ion battery, especially a dynamic sodium ion battery, can effectively improve the high-temperature and high-voltage cycle performance, especially the high-temperature stability, of the battery.

Technical solutions of the invention:

The present invention provides a mono-crystalline cathode material for sodium-ion battery, wherein the mono-crystalline cathode material for sodium-ion battery contains an element having a composition shown in chemical formula 1,

the chemical formula 1 is $Na_{1+a}Ni_{1-x-y-z-c}Mn_xFe_yM_zN_cO_2$, wherein $-0.40 \leq a \leq 0.25$, $0.08 \leq x \leq 0.5$, $0.05 \leq y \leq 0.5$, $0 \leq z < 0.26$, $0 < c < 0.1$, the M is a doping element, and the N is a cladding element,

the M and N are both one or a combination of two or more selected from the group consisting of Ti, Zn, Co, Mn, Al, Zr, Y, Ca, Li, Rb, Cs, W, Ce, Mo, Ba, Mg, Ta, Nb, V, Sc, Sr, B, F, P or Cu elements.

Preferably, in the cathode material for a single crystal sodium ion battery, $-0.40 \leq a \leq 0$, $0.15 \leq x \leq 0.5$, $0.15 \leq y \leq 0.5$.

Preferably, in the mono-crystalline cathode material for sodium-ion battery, the M is one or a combination of two or more selected from the group consisting of Zn, Ti, Co, Al, Zr, Y, Ca, Li, Rb, Cs, W, Ce, Mo, Ba, Mg, Ta, Nb, V, Sc, Sr, B, F, P or Cu, preferably the M is one or a combination of two or more selected from the group consisting of Zn, Al, B, Ti, Ca, Y, Mg, Nb, Zr or Cu, more preferably Zn; preferably, $0 \leq z \leq 0.13$.

Preferably, in the mono-crystalline cathode material for sodium-ion battery, the N is one or a combination of two or more selected from the group consisting of Al, Ti, Co, Mn, Y, B, F, P, Nb, Zr, W, Sr or Mg, preferably one or more of Al, Ti, B, Nb or Mg; preferably, $0 < c < 0.05$.

Preferably, a microscopic morphology of the mono-crystalline cathode material for sodium-ion battery under a scanning electron microscope is a mono crystal morphology; preferably, particles of the mono crystal morphology are one or a combination of two or more selected from the group consisting of spherical, spheroidal, polygonal or lamellar in shape.

Preferably, the mono-crystalline cathode material for sodium-ion battery has a powder X-ray diffraction spectrum (XRD) in which a full width at half maximum (FWHM)(110) of a (110) diffraction peak having a diffraction angle 2 $\theta$ of around 64.9° ranges 0.08-0.35.

Preferably, the mono-crystalline cathode material for sodium-ion battery has a powder compacted density of 2.8-4.2 g/cm$^3$ at a pressure of 7000-9000 kg.

Preferably, the mono-crystalline cathode material for sodium-ion battery has a moisture mass content of less than 1500 ppm, preferably less than 1000 ppm, more preferably less than 900 ppm.

Preferably, the mono-crystalline cathode material for sodium-ion battery has a pH within 12.6.

Preferably, the mono-crystalline cathode material for sodium-ion battery has a specific surface area of 0.35-1.2m$^2$/g.

Preferably, the mono-crystalline cathode material for sodium-ion battery has a particle size D$_v$50 of 2.00-16.0$\mu$m, preferably 2.50-12.0$\mu$m.

The present invention also provides a preparation method of the mono-crystalline cathode material sodium-ion battery, comprising the following steps of:

(1) mixing raw materials comprising a sodium source compound, a manganese source compound and an iron source compound, and adding and mixing a nickel source compound and an M source compound according to needs, then performing a first sintering and crushing to obtain a semi-finished product;

(2) mixing the semi-finished product obtained in step (1) with an N source compound, then performing a second sintering and crushing to obtain the mono-crystalline cathode material for sodium-ion battery.

Preferably, in the preparation method, a temperature of the first sintering in step (1) is 860-990°C, preferably 880-980°C; preferably, a constant temperature time is 6-40 hours.

Preferably, in the preparation method, a temperature of the second sintering in step (2) is 350-900°C, preferably 350-800°C; preferably, a constant temperature time is 2-15 hours.

Preferably, in the preparation method, the crushing pressure in each of the step (1) and the step (2) is 0.1-1MPa.

Preferably, in the preparation method, the sodium source compound comprises a sodium element-containing salt and/or hydroxide; preferably, the sodium source compound is one or a combination of two or more selected from the group consisting of sodium carbonate, sodium formate, sodium hydroxide, sodium acetate, sodium chloride and sodium fluoride.

Preferably, in the preparation method, the manganese source compound is one or a combination of two or more selected from the group consisting of an oxide, a hydroxide, or a salt containing a manganese element; preferably, the manganese source compound is one or a combination of two or more selected from the group consisting of manganese trioxide, manganese tetroxide, manganese oxide, manganese carbonate, manganese oxalate, manganese sulfate, manganese acetate, manganese chloride and manganese nitrate.

Preferably, in the preparation method, the nickel source compound is one or a combination of two or more selected from the group consisting of an oxide, a hydroxide or a salt containing a nickel element; preferably, the nickel source compound is one or a combination of two or more selected from the group consisting of nickel carbonate, nickel oxalate, nickel sulfate, nickel acetate, nickel chloride and nickel nitrate.

Preferably, in the preparation method, the iron source compound is one or a combination of two or more selected from the group consisting of oxides, hydroxides or salts containing an iron element; preferably, the iron source compound is one or a combination of two or more selected from the group consisting of ferric oxide, ferrous oxalate, ferrous sulfate, ferrous acetate and ferrous nitrate.

Preferably, in the preparation method, the M source compound comprises an M element-containing oxide and/or salt; preferably, the M source compound is one or a combination of two or more selected from the group consisting of calcium oxide, calcium hydroxide, diboron trioxide, boric acid, niobium oxide, aluminum oxide, titanium oxide, magnesium oxide, copper oxide, yttrium trioxide, zirconium oxide, sodium fluoride, lithium fluoride, copper oxide, zinc oxide, and copper sulfate.

Preferably, in the preparation method, the N source compound comprises an N element-containing oxide and/or salt; preferably, the N source compound is one or a combination of two or more selected from the group consisting of calcium oxide, boron trioxide, boric acid, niobium oxide, aluminum oxide, aluminum acetate, aluminum nitrate, titanium oxide, magnesium oxide, magnesium acetate, magnesium nitrate, copper oxide, yttrium trioxide, zirconium oxide, zirconium acetate, sodium fluoride, lithium fluoride, titanium dioxide, titanium oxide dispersion, zinc oxide, and copper sulfate.

The present invention also provides a mono-crystalline cathode material for sodium-ion battery prepared by the above-mentioned preparation method.

The present invention also provides a positive electrode for a sodium ion battery, an active material of which is the mono-crystalline cathode material for sodium-ion battery described above.

The present invention also provides a sodium ion battery comprising the positive electrode for a sodium ion battery described above.

The present invention also provides an application of the above-mentioned mono-crystalline cathode material for sodium-ion battery or the above-mentioned positive electrode for a sodium ion battery or the above-mentioned sodium ion battery in solar power generation, wind power generation, smart grids, distributed power stations, household energy storage batteries, low-end two-wheeled vehicle batteries or low energy density power batteries.

The invention has the following beneficial effects.

(1) The mono-crystalline cathode material for sodium-ion battery according to the present invention has a specific chemical composition and a mono crystal morphology, so that the cathode material for a sodium ion battery has good structural stability and does not undergo significant structural change due to frequent de-intercalation of sodium ions during charge and discharge of the sodium ion battery. In addition, the material has complete structure and good processability, and there will be no particle fragmentation during circulation, and effectively preventing the direct contact of the material surface with the electrolyte, especially with HF in the electrolyte. It prevents the occurrence of side reactions, and improves the circulation stability of the sodium ion battery.

(2) In the present invention, by coating treatment, the mono-crystalline cathode material for sodium ion battery has a low pH value, a low residual alkali amount and a low moisture content, so that the mono-crystalline cathode material for sodium-ion battery does not gel due to water absorption during the battery slurry conditioning process, thereby improving the stability of the electrode slurry of the sodium ion battery, thereby further improving the cycle stability of the sodium ion battery.

**Brief Description of the Drawings**

Fig. 1 is an SEM diagram of a mono-crystalline cathode material for sodium-ion battery prepared in example 1 (magnification: 5000 times);

Fig. 2 is an SEM diagram of a mono-crystalline cathode material for sodium-ion battery prepared in example 2 (magnification: 5000 times);

Fig. 3 is an SEM diagram of a mono-crystalline cathode material for sodium-ion battery prepared in example 3 (magnification: 5000 times);

Fig. 4 is an SEM diagram of a mono-crystalline cathode material for sodium-ion battery prepared in example 4 (magnification: 5000 times);

Fig. 5 is an SEM diagram of a mono-crystalline cathode material for sodium-ion battery prepared in example 5 (magnification: 5000 times);

Fig. 6 is an SEM diagram of a mono-crystalline cathode material for sodium-ion battery prepared in example 6 (magnification: 5000 times);

Fig. 7 is an SEM diagram of a mono-crystalline cathode material for sodium-ion battery prepared in example 7 (magnification: 5000 times);

Fig. 8 is an SEM diagram of a mono-crystalline cathode material for sodium-ion battery prepared in example 8 (magnification: 5000 times);

Fig. 9 is an SEM diagram of a pole piece containing a mono-crystalline cathode material for sodium-ion battery prepared in example 1 (magnification: 5000 times);

Fig. 10 is an SEM diagram of a pole piece containing a mono-crystalline cathode material for sodium ion battery prepared in example 2 (magnification: 5000 times);

Fig. 11 is an SEM diagram of a pole piece containing a mono-crystalline cathode material for sodium-ion battery prepared in example 3 (magnification: 5000 times);

Fig. 12 is an SEM diagram of a pole piece containing a mono-crystalline cathode material for sodium-ion battery prepared in example 4 (magnification: 5000 times);

Fig. 13 is an SEM diagram including a pole piece of a mono-crystalline cathode material for sodium-ion battery prepared in example 5 (magnification: 5000 times);

Fig. 14 is an SEM diagram of a pole piece containing a mono-crystalline cathode material for sodium-ion battery prepared in example 6 (magnification: 5000 times);

Fig. 15 is an SEM diagram of a pole piece containing a mono-crystalline cathode material for sodium-ion battery prepared in example 7 (magnification: 5000 times );

Fig. 16 is an SEM diagram of a pole piece containing a mono-crystalline cathode material for sodium-ion battery prepared in example 8 (magnification: 5000 times);

Fig. 17 is an SEM diagram of a mono-crystalline cathode material for sodium-ion battery prepared in example 9 (magnification: 5000 times);

Fig. 18 is an SEM diagram of a pole piece containing a mono-crystalline cathode material for sodium-ion battery prepared in example 9 (magnification: 5000 times);

Fig. 19 is an SEM diagram of the positive pole piece after 50 cycles of BA-C1 battery (magnification: 5000 times);

Fig. 20 is a graph of the strike cycle of examples 1-9.

## Detailed Description of the Invention

In order to make the objects, technical solutions and technical effects of the examples of the present invention clearer, the technical solutions of the examples of the present invention are described clearly and completely. The examples described below are some, but not all examples of the present invention. In combination with the examples of the present invention, all other examples obtained by a person of ordinary skill in the art without inventive effort fall within the scope of the present invention.

The $D_v50$ of the present invention refers to the particle size corresponding to 50% in quantity amount of the volume cumulative particle size distribution in a sample.

In order to improve the cycle performance of the sodium ion battery, the cathode material for sodium-ion battery is prepared into mono crystal particles in the present invention. The structural stability of the material is improved, the structural change is effectively suppressed, and the reversibility of the material is enhanced. At the same time, surface coating or body phase doping and surface coating modification are performed on the cathode material for sodium-ion battery, which effectively avoids the direct contact between the material and the electrolyte, especially the HF in the electrolyte, thereby preventing the occurrence of side reactions, inhibiting the crystal phase change of the material, and improving the cycling stability of the material.

In an embodiment of the present invention, the present invention provides a mono-crystalline cathode material for sodium-ion battery, wherein the material contains an element having a composition shown in chemical formula 1,

the chemical formula 1 is $Na_{1+a}Ni_{1-x-y-z-c}Mn_xFe_yM_zN_cO_2$, wherein $-0.40 \leq a \leq 0.25$, $0.08 \leq x \leq 0.5$, $0.05 \leq y < 0.5$, $0.0 \leq z < 0.26$, $0 < c < 0.1$, M is a doping element, and N is a cladding element,

the M and N are both one or a combination of two or more selected from the group consisting of Ti, Zn, Co, Mn, Al, Zr, Y, Ca, Li, Rb, Cs, W, Ce, Mo, Ba, Mg, Ta, Nb, V, Sc, Sr, B, F, P or Cu elements.

In a preferred embodiment of the present invention" in the above-mentioned chemical formula 1, $-0.40 \leq a \leq 0$, $0.15 \leq x \leq 0.5$, $0.15 \leq y \leq 0.5$.

In a preferred embodiment of the present invention,, the M is one or a combination of two or more selected from the group consisting of Zn, Ti, Co, Al, Zr, Y, Ca, Li, Rb, Cs, W, Ce, Mo, Ba, Mg, Ta, Nb, V, Sc, Sr, B, F, P or Cu, preferably the M is one or a combination of two or more selected from the group consisting of Zn, Al, B, Ti, Ca, Y or Cu, more preferably the M is Zn; preferably, $0 \leq z < 0.13$.

In yet another preferred embodiment of the present invention, the N is one or a combination of two or more selected from the group consisting Ti, Co, Mn, Y, B, F, P, Nb, Zr, W, Sr or Mg, preferably the N is one or a combination of two or more selected from the group consisting of Al, Ti, B, Nb or Mg; preferably, $0 < c < 0.05$.

In yet another preferred embodiment of the present invention, a microscopic morphology of the mono crystal cathode material for sodium-ion battery under a scanning electron microscope is a mono crystal morphology; particles of the mono crystal morphology is one or a combination of two or more selected from the group consisting of spherical, spheroidal, polygonal or lamellar in shape.

In the present invention, the mono-crystalline cathode material for sodium-ion battery has a powder X-ray diffraction spectrum (XRD) in which a full width at half maximum (FWHM)(110) of a (110) diffraction peak having a diffraction angle 2 $\theta$ of around 64.9°(it is around the diffraction angle X° appearing in the present invention, meaning that the diffraction angle is X° ± 1°, such as 64.9° ± 1°, i.e., 63.9°-65.9°) ranges 0.08-0.35.

In the present invention, the mono-crystalline cathode material for sodium-ion battery has a powder compacted density of 2.8-4.2g/cm$^3$ at a pressure of 7000-9000kg.

In the present invention, the mono-crystalline cathode material for sodium-ion battery has a specific surface area of 0.35-1.2m$^2$/g.

In the present invention, the mono-crystalline cathode material for sodium-ion battery has a particle size D$_v$50 of 2.00-16.0μm, preferably 2.50-12.0μm.

Since the mono-crystalline cathode material for sodium-ion battery of the present application has the above-mentioned specific chemical composition and morphology, the specific surface area (BET) of the material is within a reasonable range, and the intermolecular forces on the surface of the material are in a relatively balanced position. Even in an environment with a relatively high humidity, it is not easy to self-agglomerate, so that the moisture mass content of the material is at a relatively low level.

In the present invention, the mono-crystalline cathode material for sodium-ion battery has a moisture mass content of less than 1500 ppm, preferably less than 1000 ppm, more preferably less than 900 ppm.

In the present invention, the mono-crystalline cathode material for sodium-ion battery has a pH within 12.6.

Since the mono-crystalline cathode material for sodium-ion battery of the present application has the above-mentioned specific chemical composition and morphology, and is coated, the mono-crystalline cathode material for sodium-ion battery has a low pH value, a low residual alkali amount and a low moisture mass content, so that themono-crystalline cathode material for sodium-ion battery does not gel due to water absorption during the battery slurry adjusting process, thereby improving the stability of the sodium battery electrode slurry.

The present invention also provides a preparation method for the mono-crystalline cathode material for sodium-ion battery, which comprises at least two times of sintering and two times of crushing.

In a preferred embodiment of the present invention, the preparation method comprises the following steps:

(1) mixing raw materials comprising a sodium source compound, a manganese source compound and an iron source compound, and adding raw materials of a nickel source compound and an M source compound according to needs, then performing a first sintering and crushing to obtain a semi-finished product; and

(2) mixing the semi-finished product obtained in step (1) with a raw material of an N source compound, then performing a second sintering and crushing to obtain the cathode material for a single crystal sodium ion battery.

In the above-mentioned preparation method, the first sintering in step (1) is performed at a temperature of 860-990°C for 6-40 hours, preferably, the temperature of the first sintering is 880-980°C; the atmosphere used for sintering is air, oxygen or a mixed gas of air and oxygen;

In step (2) the second sintering is performed at a temperature of 350-900°C for 2-15 hours, preferably, the temperature of the second sintering is 350-800°C; the atmosphere used for sintering is air, oxygen or a mixed gas of air and oxygen;

The crushing pressure in each of the step (1) and the step (2) is 0.1-1MPa.

In the above-mentioned preparation method, the sodium source compound is a sodium-containing salt and/or hydroxide, for example, including one or a combination of two or more selected from the group consisting of sodium carbonate, sodium formate, sodium hydroxide, sodium acetate, sodium chloride, and sodium fluoride.

In the above-mentioned preparation method, the manganese source compound is one or a combination of two or more selected from the group consisting of a manganese-containing oxide, hydroxide, or manganese-containing salt, including, for example, including one or a combination of two or more selected from the group consisting of manganese trioxide, manganese tetroxide, manganese oxide, manganese carbonate, manganese oxalate, manganese sulfate, manganese acetate, manganese chloride, and manganese nitrate.

In the above-mentioned preparation method, the nickel source compound is one or a combination of two or more selected from the group consisting of a nickel-containing oxide, hydroxide, or nickel-containing salt, including, for example, including one or a combination of two or more selected from the group consisting of nickel carbonate, nickel oxalate, nickel sulfate, nickel acetate, nickel chloride, and nickel nitrate.

In the above-mentioned preparation method, the iron source compound is one or a combination of two or more selected from the group consisting of an iron-containing oxide, hydroxide or iron-containing salt, for example, including one or a combination of two or more selected from the group consisting of ferric oxide, ferrous oxalate, ferrous sulfate, ferrous acetate and ferrous nitrate.

In the above-mentioned preparation method, the M source compound includes an M element-containing oxide and/or salt, for example, including one or a combination of two or more selected from the group consisting of calcium oxide, calcium hydroxide, boron trioxide, boric acid, niobium oxide, aluminum oxide, titanium oxide, magnesium oxide, copper oxide, yttrium trioxide, zirconium oxide, sodium fluoride, lithium fluoride, copper oxide, zinc oxide, and copper sulfate.

In the preparation method, the N source compound includes an N element-containing oxide and/or salt, for example, including one or a combination of two or more selected from the group consisting of calcium oxide, boron trioxide, boric acid, niobium oxide, aluminum oxide, aluminum acetate, aluminum nitrate, titanium oxide, magnesium oxide, magnesium acetate, magnesium nitrate, copper oxide, yttrium trioxide, zirconium oxide, zirconium acetate, sodium fluoride, lithium fluoride, titanium dioxide, titanium oxide dispersion, zinc oxide, and copper sulfate.

The present invention also provides a positive electrode for a sodium ion battery, an active material of which is the cathode material for sodium ion battery described above.

The present invention also provides a sodium ion battery comprising the positive electrode for a sodium ion battery described above.

The sodium ion battery of the present invention further comprises a negative electrode, an electrolyte comprising a sodium salt, a separator, and an aluminum plastic film. Specifically, wherein the positive is made of a material including a positive current collector and a positive active material coated on the positive current collector, a binder, and a conductive aid, etc. The positive active material is the cathode material of the present invention. The negative electrode is a metal sodium sheet or is made of a material comprising a current collector and a negative active substance coated on the current collector, and a binder, a conductive aid, etc. The separator is a PP/PE thin film conventionally used in the art for separating a positive electrode and a negative electrode from each other. The aluminum-plastic film is an inclusion body of a positive electrode, a negative electrode, a separator, and an electrolyte.

The adhesive in the present invention is mainly used for improving adhesion characteristics between positive active material particles and each other and between positive active material particles and a current collector. The adhesive of the present invention may be selected from conventional adhesives commercially available in the art. In particular, the adhensive may be one or a combination of two or more selected from the group consisting of polyvinyl alcohol, carboxymethyl cellulose, hydroxypropyl cellulose, polyvinyl chloride, carboxylated polyvinyl chloride, polyvinyl fluoride, ethylene oxide containing polymers, polyvinyl pyrrolidone, polyurethane, polytetrafluoro ethylene, polyvinylidene 1,1-difluoride, polyethylene, polypropylene, styrene-butadiene rubber, acrylated styrene-butadiene rubber, epoxy or nylon.

The conductive aid of the present invention may be selected from conventional conductive aids commercially available in the art. In particular, the conductive aid may be one or a combination of two or more selected from the group consisting of a carbon-based material (e.g. natural graphite, artificial graphite, carbon black, acetylene black, ketjen black, or carbon fiber), a metal-based material (e.g. metal powder or metal fibers including copper, nickel, aluminum, silver, etc.), or a conductive polymer (e.g. a polyphenylene derivative).

The present invention also provides use of the above-mentioned mono-crystalline cathode material for sodium-ion battery or the above-mentioned electrode for a sodium ion battery or the above-mentioned sodium ion battery in solar power generation, wind power generation, smart grids, distributed power stations, household energy storage batteries, low-end two-wheeled vehicle batteries or low energy density power batteries.

Benefits of the present invention are further illustrated by the following specific examples.

The raw materials or reagents used in the present invention are commercially available from mainstream manufacturers. Those in which manufacturers are not specified or concentrations not specified are analytically pure raw materials or reagents that can be conventionally obtained, provided that they can perform the intended function, without particular limitation. The equipments and equipments used in this example are all purchased from major commercial manufacturers, and are not particularly limited as long as they can perform the intended functions. Where specific techniques or conditions are not specified in the examples, they are performed according to techniques or conditions described in the literature in the art or according to the product manual. The materials and instruments used in the following examples, comparative examples, are listed in Table 1:

Table 1 Raw materials used in examples and comparative examples

| Name of the agent | Grade | Model | Vendor |
|---|---|---|---|
| Sodium carbonate | / | / | Guizhou Golden Molar Chemical Co., Ltd. |
| Manganese carbonate | / | / | Shandong Pule New Material Co., Ltd. |
| Nickel carbonate | / | / | Baoding Fairsky Industrial Co., Ltd. |
| Ferric oxide | / | / | Hengshengyuan New Material Technology Co., Ltd. |
| Boron oxide | / | / | Guizhou Tianlihe Chemical Co., Ltd. |
| Alumina | / | / | Shijiazhuang Jinghuang Technology Co., Ltd. |
| Cupric oxide | / | / | Guizhou Tianlihe Chemical Co., Ltd. |

(continued)

| Name of the agent | Grade | Model | Vendor |
|---|---|---|---|
| Titanium oxide | / | / | Nanjing Tansail New Material Co., Ltd. |
| Manganese sesquioxide | / | / | Haotian Nanotechnology (Shanghai) Co., Ltd. |
| Nickel oxalate | / | / | Zhengzhou Lanzhituo Chemical Products Co., Ltd. |
| Ferrous oxalate | / | / | Guizhou Tianlihe Chemical Co., Ltd. |
| Zinc oxide | / | / | Guizhou Tianlihe Chemical Co., Ltd. |
| Magnesium oxide | / | / | Shijiazhuang Jinghuang Technology Co., Ltd. |
| Aluminum nitrate nonahydrate | / | / | Xilong Scientific Co., Ltd. |

Table 2 Equipment information used in the examples

| Name of the equipment | Model | Manufacturer |
|---|---|---|
| Laser particle size analyzer | MSU2000 | British Malvern Instruments Co., Ltd. |
| Micromeritics automatic specific surface and porosity analyzer | TriStar II 3020 | Micromeritics |
| Powder ray diffractometer | X'Pert PRO MPD | PANalytical |
| Inductively coupled plasma emission spectrometer | iCAP-7400 | Thermo Electric |
| Battery test system | CT-4008-5V50mA-164 | Shenzhen Neware Technology Co., Ltd. |
| High-efficiency vacuum drying box | KP-BAK-03E-02 | Dongguan Kerui Electromechanical Equipment Co., Ltd. |
| Jet mill | MX-50 | Yixing City Juneng Superfines Equipment Co., Ltd. |
| Muffle furnace | JZ-24-1200 | Shanghai Jingzhao Machinery Equipment Co., Ltd. |

**Example 1**

According to an elemental molar ratio of Na:Mn:Ni:Fe:B=0.87:0.33:0.33:0.33:0.01 and a total weight of 1.59kg, corresponding weights of sodium carbonate, manganese carbonate, nickel carbonate, ferric oxide and boron oxide were respectively weighed, and then added into an ultra-high speed multi-functional mixer to rotate at a speed of 4000r/min, and mixed for 20min. The uniformly mixed material was placed in a muffle furnace under an air atmosphere at a constant temperature of 870°C for 12 hours, then naturally cooled, and crushed with a jet mill at a crushing pressure of 0.62MPa to obtain a semi-finished product;
1.08 kg of the above-mentioned semi-finished product and 0.0097kg of alumina were weighed, added into a ball mill jar, ball-milled at 40Hz for 10min, and then the uniformly mixed material was placed in a muffle furnace under an air atmosphere at a constant temperature of 800°C for 4 hours, and then naturally cooled, crushed with a jet mill at a crushing pressure of 0.58MPa, and sieved to obtain a mono-crystalline cathode material for sodium-ion battery C1.

The above-mentioned cathode materials were characterized and analyzed according to the following method:

1) Component analysis

Composition of the above-mentioned cathode material were analysed using ICP

(1) Sample pretreatment

0.2000-0.2100 (accurate to 0.001g) sample was weighed into a 100mL quartz beaker, 10mL aqua regia (prepared according to the volume ratio of 37wt% concentrated hydrochloric acid and 65wt% concentrated nitric acid as 1:1) was added into the quartz beaker along the cup wall, The quarts beaker was covered with a watch glass, and heated at 180°C for 30min. All the solution was transferred to 50mL of capacity and shaked well with deionized water at constant volume; 1mL of solution was pipetted from the shaken 50mL of volumetric flask into a 100mL of volumetric flask, 5mL (25%) of nitric acid was added into the volumetric flask, diluted with deionized water to constant volume;

(2) Component analysis testing was performed using the standard curve method.

The chemical formula of the mono-crystalline cathode material for sodium-ion battery C1 measured according to the above-mentioned method is $Na_{0.87}Ni_{0.32}Mn_{0.32}Fe_{0.33}B_{0.01}Al_{0.02}O_2$

2) Specific surface area

According to the national standard GB/T19587-2006 Gas adsorption-BET method , a specific surface area of solid materials was determined.

Analytical equipment: Tristar II3020 automatic specific surface and porosity analyzer; Test Parameters: adsorbate $N_2$, 99.999%, coolant liquid nitrogen, P0 actual measurement, volume measurement mode, adsorption pressure deviation of 0.05mmHg, equilibrium time of 5s, relative pressure point selection P/P0: 0.05; 0.1; 0.15; 0.2; 0.25; 0.30;

Sample pretreatment; the empty sample tube+stopper mass was weighed and recorded as Mi, 3.8-4.2g was weighed, 3/8 inch of 9.5mm ratio meter tube with bulb was added, FlowPrep 060 degassing station was used to set 200°C, purging was performed with inert gas to heat and degas for 0.5h, the sample tube+stopper+sample mass cooled to room temperature was removed and recorded as $M_2$, the sample mass $M = M_2 - M_1$, and test was performed on the machine to record the BET value. The results are shown in Table 3.

3) Particle size

Determination was made according to the national standard GB/T19077-2016 particle size distribution laser diffraction method, and the results are shown in Table 3.

Test equipment: Malvern, Master Size 2000 Laser Particle Size Analyzer.

Test steps: 1g of powder was weighed. The powder were dded into 60ml of pure water, and externally sonicated for 5min. The sample was poured into the sampler, and then the test was conducted, and the test data was recorded. Conditions tested: the test principle is (light scattering) Mie theory 2000, the detection angle is 0-135°, the external ultrasonic intensity is 40KHz, 180w, the particle refractive index is 1.692, the particle absorption rate is 1, the sample test time is 6s, the background test snap number is 6,000 times, and the obscuration is 8-12%.

4) pH value

A PHSJ-3F lightning magnetic pH meter is used to make measurement, and the specific method is as follows: 5g $\pm$ 0.05g sample was accurately weighed, 10% suspension were prepared by adding deionized water, wherein the mass ratio of material to water is 1:9, and then the magnet was put into it, placing on the tray of magnetic stirrer. Magnetic stirrer was started to work with speed of 880r/min. After 5min, qualitative filter paper and funnel were used to filter the mixed solution, which was then put into a thermostatic water bath set at 25°C, and thermostatic filtration was perform at 20 $\pm$ 5min; the electrode was washed with the sample solution. After washing, the electrode and temperature sensor were inserted into the sample solution. When the reading was stable and the temperature shows 25°C, the pH value was recorded. The results are shown in Table 3.

5) XRD Test

The cathode material for sodium-ion battery of the present invention was tested for XRD using an X 'Pert PRO MPD analyzer.

Test principle: the Bragg equation reflects the relationship between the direction of the diffraction lines and the crystal structure. The diffraction must satisfy the Bragg formula: $2d\sin\theta=n\lambda$ (d: interplanar spacing; $\theta$: Bragg angle; $\lambda$: the wavelength of the X-rays; n: reflection order). When X-rays irradiate on a sample, the scattered X-rays of the atoms in the crystal interfere produce strong X-ray diffraction lines in a particular direction. When X-rays irradiate the sample at different angles, diffraction occurs at different crystal planes, and the detector will receive the number of diffracted photons reflected from the crystal plane, thereby obtaining a spectrum of angle versus intensity.

Test conditions: the light pipe is a Cu target, the wavelength is 1.54060, and a Be window is used; Incident light path: cable slit of 0.04rad, divergence slit of 1/2°, shading plate of 10mm, anti-scatter slit of 1°; diffraction light path:

anti-scatter slit of 8.0mm, cable slit of 0.04rad, large Ni filter; scan range of 10-90°, scan step size of 0.013°, dwell time of 30.6s per step, voltage of 40kV, current of 40mA.

Powder sample preparation: the powder was put into the groove of a glass slide by a clean sampling spoon (for a large-particle sample, it was necessary to grind it into powder < 50 $\mu$m). One side (> 20 mm) of scraping blade was placed against the surface of glass slide, and the other end was slightly lifted (at an included angle < 10°). The surface of powder sample was scraped flatly by the edge of scraping blade, and scraped flatly again when the glass slide rotated by 90°. It was repeatedly scraped in two directions for several times until the surface of sample was free from texture. After removing the excess powder around the glass slide, the glass slide was placed into a powder ray diffraction analyzer.

Sample analysis: the XRD graph is refined using the software High-Score Plus, including firstly determining the background, selecting a peak to confirm the peak, repeating the fitting, recording the Williamson-Hall plot to calculate the grain size, selecting a corresponding phase to perform the matching and unit cell refinement, and recording unit cell parameters. The results were shown in Table 3.

6) Moisture

According to GB/T 11133-2015 Karl Fischer coulometric titration, 899 Coulometer + 885 Compact Oven SC coulometric water content determination equipment was used to make measurement. Including weighing 0.5-0.8g sample with accuracy of 0.0001g using water content bottle, extracting 400s in the air flow rate of 50-60ml/min with heat temperature of 170°C. The start drift is greater than or equal to 10$\mu$g/min, stop drift is 20$\mu$g/min. The test result was kept by one decimal place. The results are shown in Table 3.

7) powder compacted density

 (1) the circular mould of sample is placed on the working table of electronic pressure testing machine, the pressure was slowly manually increased to 1000kg, and then the displacement and deformation were cleared.

 (2) The sample bag was placed on an electronic balance, the skin was peeled off, taking (5.0000 $\pm$ 0.1000) powder was taken with a spoon and added into a circular mould, gently shaken flat, and then the upper gasket of the mould was placed on the sample. Note that it is necessary for both gaskets to face the sample in a non-tangential plane, so as to prevent the sample from overflowing.

 (3) After the completion of sample loading, the mold was placed on the working surface of electronic pressure testing machine, the program was edit to increase the pressure to 8000kg at the speed of 5mm/min, constant pressure was kept for 30s, and then the pressure was released to zero.

 (4) The sample pressure was recorded when the sample was at constant pressure to 8000$\pm$10kg (about 15-25s after the elevated pressure reached 8000kg), and the height of sample h was read, accurate to 0.001cm.

 (5) After reading, the working table of electronic pressure testing machine was manually descended, and the sample was taken out with extractor.

 (6) After taking out the sample, the inner part of the sample mould was cleaned with dust-free paper dipped with alcohol to ensure that the inner part of the mould is clean, and the experiment was completed.

 (7) The results were calculated according to the following formula, and the results are shown in Table 3.

$$\text{compacted density } \rho = \frac{\text{mass of sample m}}{3.14 * 1.0^2 * (\text{height of sample h})}$$

In the formula:

 m--mass of sample, g;
 1.0--radius of circular die, cm;
 h--height of sample, cm.

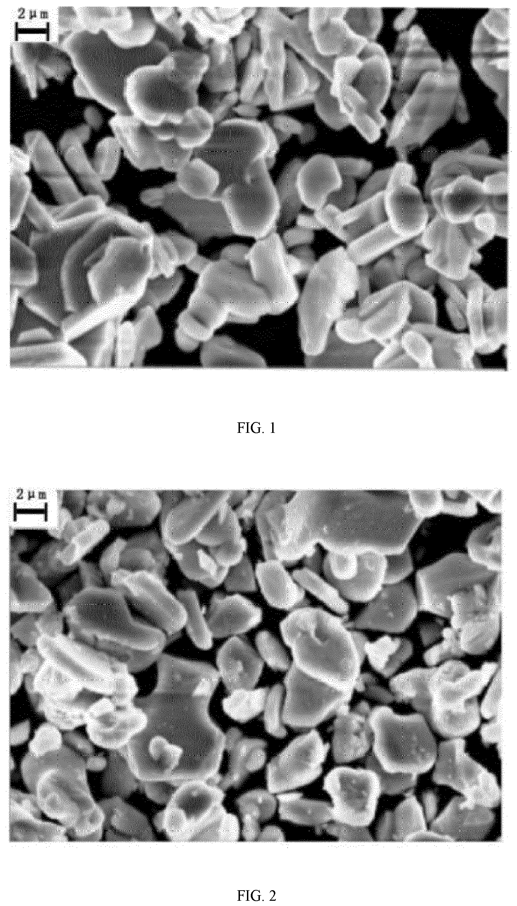

The mono-crystalline cathode material for sodium ion battery of example 1 is taken for SEM test, as shown in fig. 1, and it can be seen from fig. 1 that the material is a mono crystal particle, and the morphology thereof is polygonal and lamellar.

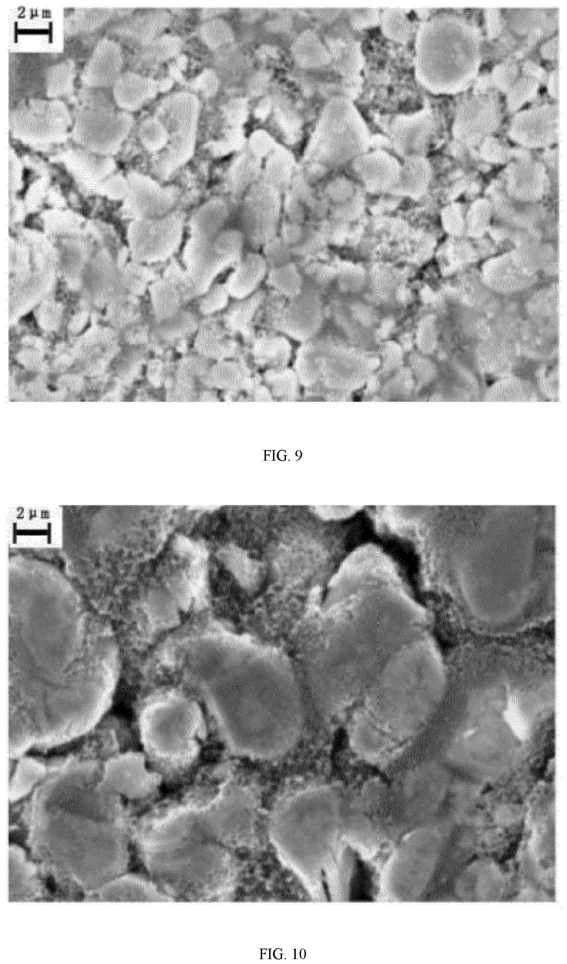

The mono-crystalline cathode material for sodium-ion battery of example 1 was thoroughly mixed with an adhesive of polyvinylidene fluoride (PVDF) and conductive carbon black (S. P) in a weight ratio of 90:5:5, stirred to form a uniform slurry, coated on an aluminium foil current collector, dried and cold pressed to form a pole piece. The pole piece was taken for an SEM test, as shown in Fig. 9, and it can be seen from Fig. 9 that the material is still mono crystal particles, and there is no crack on the surface of the material particles.

**Example 2**

According to an elemental molar ratio of Na:Mn:Ni:Fe:Cu=0.79:0.30:0.18:0.30:0.22 and a total weight of 1.46kg, sodium carbonate, manganese carbonate, nickel carbonate, ferric oxide and copper oxide were respectively weighed, and then added into an ultra-high speed multi-functional mixer to mix 20 min at a rotational speed of 4000r/min The uniformly mixed material was placed in a muffle furnace under an air atmosphere at a constant temperature of 905°C for 12 hours, then naturally cooled, and crushed with a jet mill at a crushing pressure of 0.58MPa to obtain a semi-finished product; and

1.08kg of the semi-finished product and 0.005kg of titanium oxide were weighed, added into a ball mill jar, ball-milled at 35Hz for 20min, and then the uniformly mixed material was placed in a muffle furnace under an air atmosphere at a constant temperature of 400°C for 3 hours, and then naturally cooled, crushed with a jet mill at a crushing pressure of 0.54 MPa, and sieved to obtain a mono-crystalline cathode material for sodium-ion battery C2.

The chemical formula of the mono-crystalline cathode material for sodium-ion battery C2 measured by the composition analysis method in example 1 is $Na_{0.79}Ni_{0.18}Mn_{0.295}Fe_{0.30}Cu_{0.22}Ti_{0.005}O_2$. The cathode material was tested by the method of example 1, and the test results are shown in Table 3.

The mono-crystalline cathode material for sodium-ion battery for sodium-ion battery of example 2 is taken for SEM test, as shown in Fig. 2, and it can be seen from Fig. 2 that the material is a mono crystal particle, and the morphology thereof is polygonal and lamellar.

The mono-crystalline cathode material for sodium-ion battery of example 2 was thoroughly mixed with an adhesive of polyvinylidene fluoride (PVDF) and conductive carbon black (S. P) in a weight ratio of 90:5:5, stirred to form a uniform slurry, coated on an aluminium foil current collector, dried and cold pressed to form a pole piece, and the pole piece was taken for an SEM test, as shown in fig. 10, and it can be seen from fig. 10 that the material is still single crystal particles, and there is no crack on the surface of the material particles.

**Example 3**

According to an elemental molar ratio of Na:Mn:Ni:Fe:Zn=0.85:0.30:0.18:0.30:0.22 and a total weight of 1.844kg, sodium carbonate, manganese trioxide, nickel oxalate, ferrous oxalate and zinc oxide are respectively weighed and then added into an ultra-high speed multi-functional mixer to mix 30min at a rotational speed of 3500r/min. The uniformly mixed material was placed in a muffle furnace under an air atmosphere at a constant temperature of 910°C for 10 hours, then naturally cooled, and crushed with a jet mill at a crushing pressure of 0.63MPa to obtain a semi-finished product;

1.11kg of the above-mentioned semi-finished product and 0.0025kg of magnesium oxide were weighed, added into a ball mill jar, ball-milled at 45Hz for 15min, and then the uniformly mixed material was placed in a muffle furnace under an air atmosphere at a constant temperature of 500°C for 5 hours, and then naturally cooled, crushed with a jet mill at a crushing pressure of 0.56MPa, and sieved to obtain a mono-crystalline cathode material for sodium-ion battery C3

The chemical formula of the mono-crystalline cathode material for sodium-ion battery C3 measured by the composition analysis method in example 1 is $Na_{0.88}Ni_{0.18}Mn_{0.30}Fe_{0.297}Zn_{0.22}Mg_{0.003}O_2$.

The cathode material was tested by the method of example 1, and the test results are shown in Table 3.

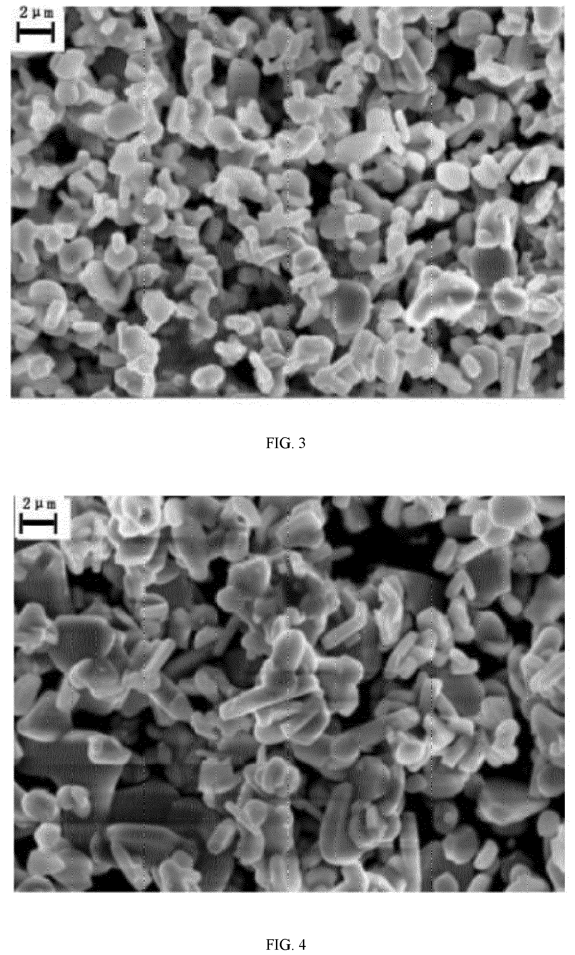

The mono-crystalline cathode material for sodium-ion battery of example 3 is taken for SEM test, as shown in Fig. 3, and it can be seen from Fig. 3 that the material is a mono crystal particle, and the morphology thereof is polygonal and lamellar.

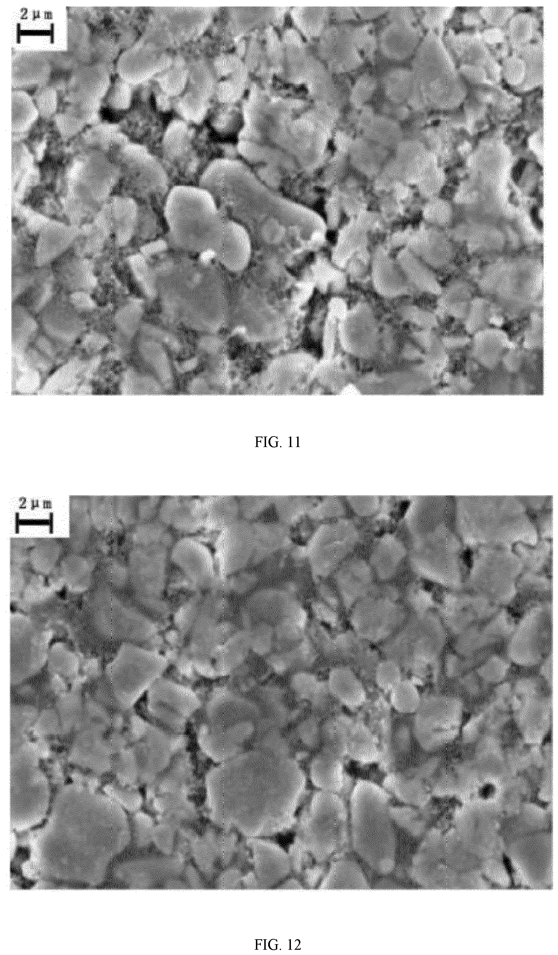

The mono-crystalline cathode material for sodium-ion battery of example 3 was thoroughly mixed with an adhesive of polyvinylidene fluoride (PVDF) and conductive carbon black (S. P) in a weight ratio of 90:5:5, stirred to form a uniform slurry, coated on an aluminium foil current collector, dried and pressed to form a pole piece, and the pole piece was taken for an SEM test, as shown in Fig. 11, and it can be seen from Fig. 11 that the material is still mono crystal particles, and there is no crack on the surface of the material particles.

**Example 4**

According to an elemental molar ratio of Na:Mn:Ni:Fe:Zn=0.88:0.30:0.18:0.30:0.22 and a total weight of 1.844kg, sodium carbonate, manganese trioxide, nickel oxalate, ferrous oxalate and zinc oxide were respectively weighed and then added into an ultra-high speed multi-functional mixer to mix 30min at a rotational speed of 3500r/min. The uniformly mixed material was placed in a muffle furnace under an air atmosphere at a constant temperature of 920°C for 15 hours, then naturally cooled, and crushed with a jet mill at a crushing pressure of 0.68MPa to obtain a semi-finished product.

0.025kg of aluminum nitrate was weighed, the weighed aluminum nitrate and pure water were prepared into an aluminum nitrate solution in a mass ratio of 1: 3 for future use, 1.11kg of the above-mentioned semi-finished product was weighed, added into water and stirred for 10 minutes, the prepared aluminum nitrate solution was added into the solution, stirring was continued for 10 minutes, suction filtration and drying were performed, the dried material was placed in a muffle furnace under an air atmosphere at 600°C for 6 hours, then naturally cooled, a jet mill was used for crushing under a crushing pressure of 0.60MPa, and sieving was performed to obtain a mono-crystalline cathode material for sodium-ion battery C4.

The chemical formula of the mono-crystalline cathode material for sodium-ion battery C4 measured by the composition analysis method in example 1 is $Na_{0.88}Ni_{0.18}Mn_{0.297}Fe_{0.291}Zn_{0.22}Al_{0.012}O_2$.

The cathode material was tested by the method of example 1, and the test results are shown in Table 3.

The mono-crystalline cathode material for sodium-ion battery of example 4 is taken for SEM test, as shown in Fig. 4, and it can be seen from Fig. 4 that the material is a mono crystal particle, and the morphology thereof is polygonal and lamellar.

The mono-crystalline cathode material for sodium-ion battery of example 4 was thoroughly mixed with an adhesive of polyvinylidene fluoride (PVDF) and conductive carbon black (S. P) in a weight ratio of 7:2:1, stirred to form a uniform slurry, coated on an aluminium foil current collector, dried and pressed to form a pole piece, and the pole piece was taken for an SEM test, as shown in Fig. 12, and it can be seen from Fig. 12 that the material is still mono crystal particles, and there is no crack on the surface of the material particles.

## Example 5

According to an elemental molar ratio of Na:Mn:Ni:Fe:Al=0.81:0.33:0.33:0.33:0.01 and a total weight of 1.56kg, corresponding weights of sodium carbonate, manganese carbonate, nickel carbonate, ferric oxide and alumina were respectively weighed, and then added into an ultra-high speed multi-functional mixer to rotate at a speed of 2800r/min, and mixed for 30min. The uniformly mixed material was placed in a muffle furnace under an air atmosphere at a constant temperature of 930°C for 10 hours, then naturally cooled, and crushed with a jet mill at a crushing pressure of 0.65MPa to obtain a semi-finished product;

1.068kg of the above-mentioned semi-finished product and 0.0074kg of boron oxide were weighed, added into a ball mill jar, ball-milled at 40Hz for 10min, and then the uniformly mixed material was placed in a muffle furnace under an air atmosphere at a constant temperature of 500°C for 3 hours, and then naturally cooled, crushed with a jet mill at a crushing pressure of 0.56MPa, and sieved to obtain a mono-crystalline cathode material for sodium-ion battery C5.

The chemical formula of the mono-crystalline cathode material for sodium-ion battery C5 measured by the composition analysis method in example 1 is $Na_{0.81}Ni_{0.33}Mn_{0.33}Fe_{0.31}Al_{0.01}B_{0.02}O_2$.

The cathode material was tested by the method of example 1, and the test results are shown in Table 3.

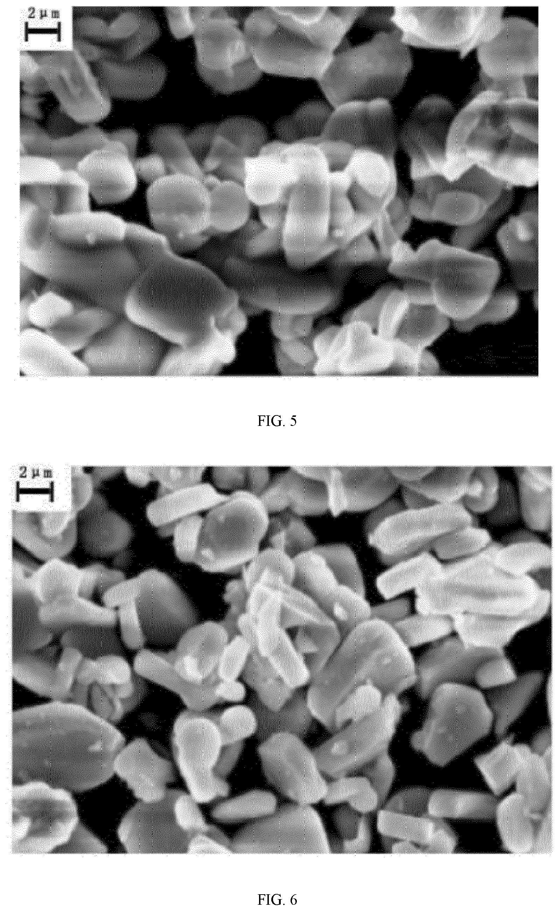

The mono-crystalline cathode material for sodium-ion battery of example 5 is taken for SEM test, as shown in Fig. 5, and it can be seen from Fig. 5 that the material is a mono crystal particle, and the morphology thereof is polygonal and lamellar.

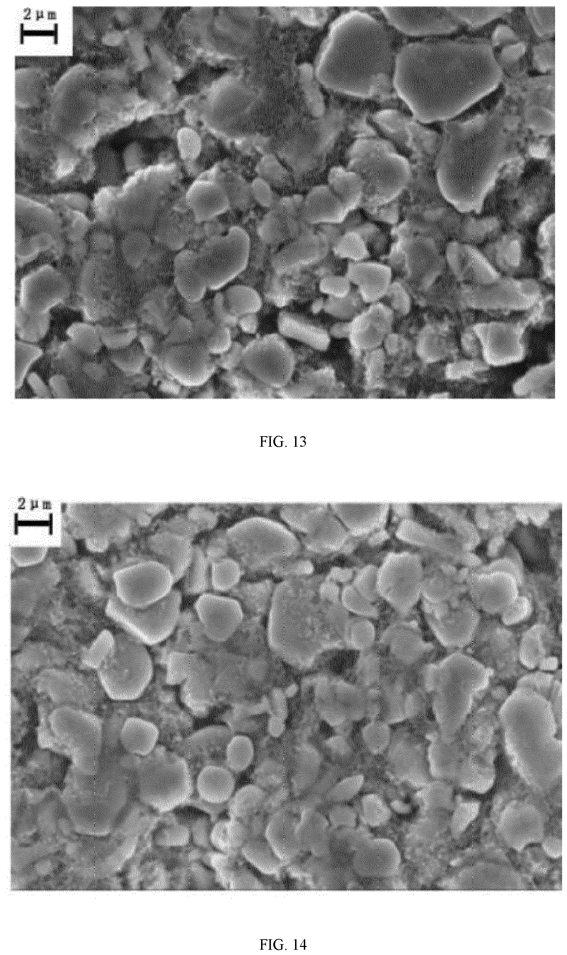

The mono-crystalline cathode material for sodium-ion battery of example 5 was thoroughly mixed with an adhesive of polyvinylidene fluoride (PVDF) and conductive carbon black (S. P) in a weight ratio of 7:2:1, stirred to form a uniform slurry, coated on an aluminium foil current collector, dried and pressed to form a pole piece, and the pole piece was taken for an SEM test, as shown in fig. 13, and it can be seen from fig. 13 that the material is still mono crystal particles, and there is no crack on the surface of the material particles.

## Example 6

According to an elemental molar ratio of Na:Mn:Ni:Fe:Zn=0.84:0.34:0.25:0.30:0.11 and a total weight of 1.77kg, sodium carbonate, manganese carbonate, nickel carbonate, ferrous oxalate and zinc oxide were respectively weighed and then added into an ultra-high speed multi-functional mixer to mix 30min at a rotational speed of 3000r/min. The uniformly mixed material was placed in a muffle furnace under an air atmosphere at a constant temperature of 980°C for 9 hours, then naturally cooled, and crushed with a jet mill at a crushing pressure of 0.66MPa to obtain a semi-finished product;

1.086kg of the above-mentioned semi-finished product and 0.048kg of niobium pentoxide were weighed, added into a ball mill jar, ball-milled at 40Hz for 20min, and then the uniformly mixed material was placed in a muffle furnace under an air atmosphere at a constant temperature of 600°C for 7 hours, and then naturally cooled, crushed with a jet mill at a crushing pressure of 0.58MPa, and sieved to obtain a mono-crystalline cathode material for sodium-ion battery C6.

The chemical formula of the mono-crystalline cathode material for sodium-ion battery C6 measured by the composition analysis method in example 1 is $Na_{0.84}Ni_{0.25}Mn_{0.34}Fe_{0.295}Zn_{0.11}Nb_{0.005}O_2$.

The cathode material was tested by the method of example 1, and the test results are shown in Table 3.

The mono-crystalline cathode material for sodium-ion battery of example 6 is taken for SEM test, as shown in Fig. 6, and it can be seen from Fig. 6 that the material is a mono crystal particle, and the morphology thereof is polygonal and lamellar.

The mono-crystalline cathode material for sodium-ion battery of example 6 was thoroughly mixed with an adhesive of polyvinylidene fluoride (PVDF) and conductive carbon black (S. P) in a weight ratio of 7:2:1, stirred to form a uniform slurry, coated on an aluminium foil current collector, dried and pressed to form a pole piece, and the pole piece was taken for an SEM test, as shown in Fig. 14, and it can be seen from Fig. 14 that the material is still single crystal particles, and there is no crack on the surface of the material particles.

**Example 7**

According to an elemental molar ratio of Na:Mn:Fe=:0.84:0.5:0.5 and a total weight of 1.61kg, sodium carbonate, manganese carbonate, and ferric oxide were respectively weighed, and then added into an ultra-high speed multi-functional mixer to rotate at a speed of 3700r/min, and mixed for 25min. The uniformly mixed material was placed in a muffle furnace under an air atmosphere at a constant temperature of 875°C for 9 hours, then naturally cooled, and crushed with a jet mill at a crushing pressure of 0.66MPa to obtain a semi-finished product;

1.072kg of the above-mentioned semi-finished product and 0.045kg of zirconium oxide were weighed, added into a ball mill jar, ball-milled at 45Hz for 15min, and then the uniformly mixed material was placed in a muffle furnace under an air atmosphere at a constant temperature of 730°C for 7 hours, and then naturally cooled, crushed with a jet mill at a crushing pressure of 0.58MPa, and sieved to obtain a mono-crystalline cathode material for sodium-ion battery C7.

The chemical formula of the cathode material C7 for a single crystal sodium ion battery measured by the composition analysis method in example 1 is $Na_{0.84}Mn_{0.497}Fe_{0.5}Zr_{0.003}O_2$.

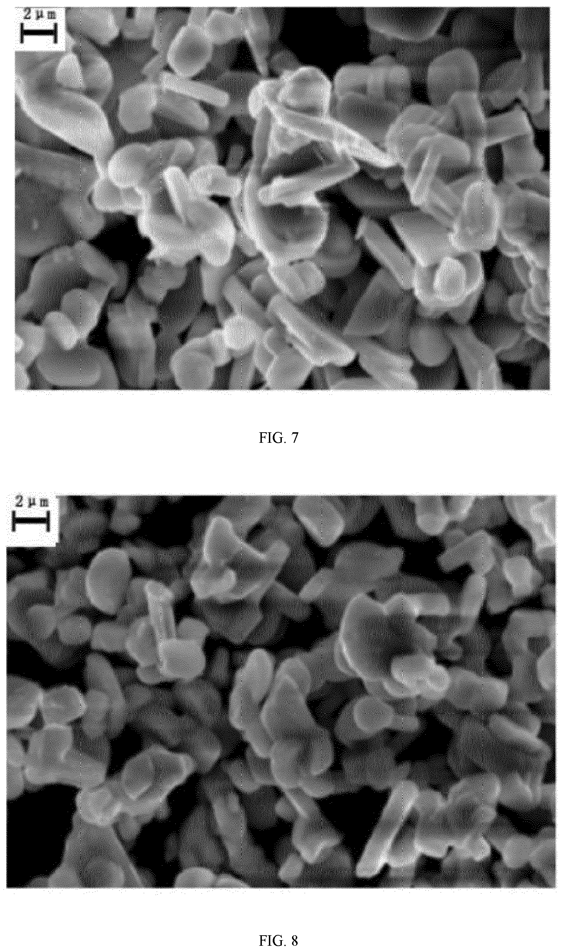

The mono-crystalline cathode material for sodium-ion battery of example 7 is taken for SEM test, as shown in Fig. 7, and it can be seen from Fig. 7 that the material is a mono crystal particle, and the morphology thereof is polygonal and lamellar.

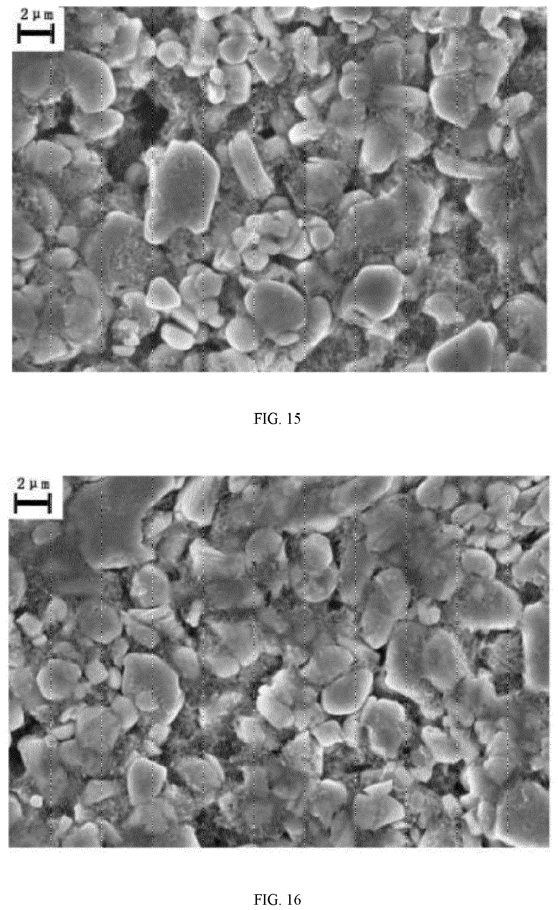

The mono-crystalline cathode material for sodium-ion battery of example 7 was thoroughly mixed with an adhesive of polyvinylidene fluoride (PVDF) and conductive carbon black (S. P) in a weight ratio of 7:2:1, stirred to form a uniform slurry, coated on an aluminium foil current collector, dried and pressed to form a pole piece, and the pole piece was taken for an SEM test, as shown in Fig. 15, and it can be seen from Fig. 15 that the material is still mono crystal particles, and there is no crack on the surface of the material particles.

**Example 8**

According to an elemental molar ratio of Na:Mn:Ni:Fe:Ti=0.91:0.1:0.42:0.32:0.16 and a total weight of 1.79kg, sodium carbonate, manganese carbonate, nickel carbonate, ferrous oxalate and titanium dioxide were respectively weighed and then added into an ultra-high speed multi-functional mixer to mix 35min at a rotational speed of 3300r/min. The uniformly mixed material was placed in a muffle furnace under an oxygen atmosphere at a constant temperature of 890°C for 10 hours, then naturally cooled, and crushed with a jet mill at a crushing pressure of 0.62MPa to obtain a semi-finished product;

0.025kg of aluminum nitrate was weighed, the weighed aluminum nitrate and pure water were prepared into an aluminum nitrate solution in a mass ratio of 1: 3 for future use, 1.072kg of the above-mentioned semi-finished product was weighed, added into water and stirred for 10 minutes, the prepared aluminum nitrate solution was added into the solution, stirring was continued for 10 minutes, suction filtration and drying were performed, the dried material was placed in a muffle furnace under an oxygen atmosphere at 550°C for 4 hours, then naturally cooled, a jet mill was used for crushing under a crushing pressure of 0.60MPa, and sieving was performed to obtain an mono-crystalline cathode material for sodium-ion battery C8.

The chemical formula of the mono-crystalline cathode material for sodium-ion battery C8 measured by the composition analysis method in example 1 is $Na_{0.91}Ni_{0.42}Mn_{0.1}Fe_{0.308}Ti_{0.16}Al_{0.012}O_2$.

The mono-crystalline cathode material for sodium-ion battery of example 8 is taken for SEM test, as shown in fig. 8, and it can be seen from fig. 8 that the material is a single crystal particle, and the morphology thereof is polygonal and lamellar.

The mono-crystalline cathode material for sodium-ion battery of example 8 was thoroughly mixed with an adhesive of polyvinylidene fluoride (PVDF) and conductive carbon black (S. P) in a weight ratio of 7:2:1, stirred to form a uniform slurry, coated on an aluminium foil current collector, dried and pressed to form a pole piece, and the pole piece was taken for an SEM test, as shown in fig. 16, and it can be seen from fig. 16 that the material is still single crystal particles, and there is no crack on the surface of the material particles.

**Example 9**

According to an elemental molar ratio of Na:Mn:Ni:Fe:Zn=0.88:0.30:0.18:0.30:0.22 and a total weight of 1.844kg, sodium carbonate, manganese trioxide, nickel oxalate, ferrous oxalate and zinc oxide were respectively weighed and then added into an ultra-high speed multi-functional mixer to mix 30min at a rotational speed of 3500r/min. The uniformly mixed material was placed in a muffle furnace under an air atmosphere at a constant temperature of 900°C for 10 hours, then naturally cooled, and crushed with a jet mill at a crushing pressure of 0.63MPa, sieved to obtain a mono-crystalline cathode material for sodium-ion battery C9;

The chemical formula of the mono-crystalline cathode material for sodium-ion battery C9 measured by the composition analysis method in example 1 is $Na_{0.88}Ni_{0.18}Mn_{0.30}Fe_{0.30}Zn_{0.22}O_2$.

The cathode material was tested by the method of example 1, and the test results are shown in Table 3.

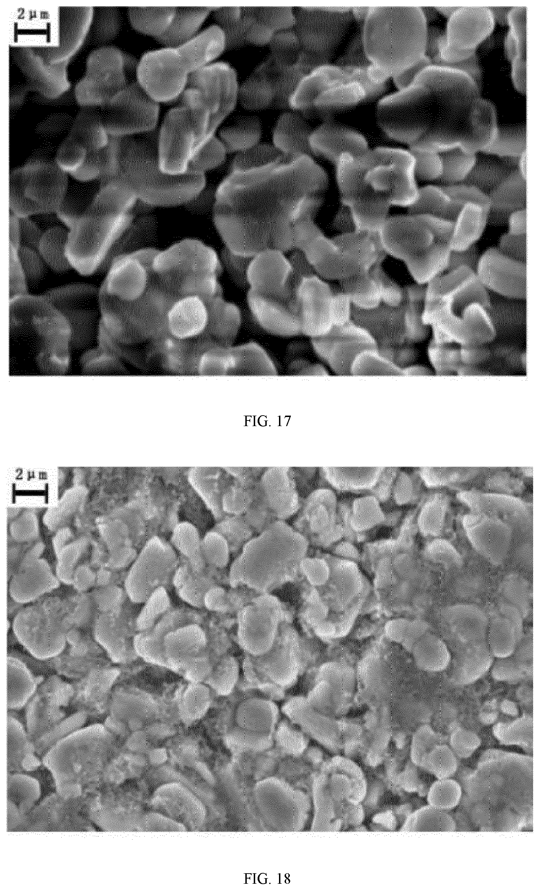

The mono-crystalline cathode material for sodium-ion battery cathode material example 9 is taken for SEM test, as shown in Fig. 17, and it can be seen from Fig. 17 that the material is a mono crystal particle, and the morphology thereof is polygonal and lamellar.

The mono-crystalline cathode material for sodium-ion battery cathode material of example 9 was thoroughly mixed with an adhesive of polyvinylidene fluoride (PVDF) and conductive carbon black (S. P) in a weight ratio of 7:2:1, stirred to form a uniform slurry, coated on an aluminium foil current collector, dried and pressed to form a pole piece, and the pole piece was taken for an SEM test, as shown in fig. 18, and it can be seen from fig. 18 that the material is still mono crystal particles, and there is no crack on the surface of the material particles.

Table 3 Performance test results of the mono-crystalline cathode material for sodium-ion battery in the examples

| | F110 | Moisture, ppm | pH | Specific surface area, $m^2/g$ | Particle size, $\mu m$ | powder compacted density, $g/cm^3$ |
|---|---|---|---|---|---|---|
| example 1 | 0.23 | 1200 | 12.47 | 0.62 | 8.30 | 3.83 |
| example 2 | 0.22 | 1030 | 12.45 | 0.31 | 10.20 | 3.61 |
| example 3 | 0.15 | 960 | 12.43 | 0.55 | 6.70 | 3.47 |
| example 4 | 0.21 | 850 | 12.37 | 0.69 | 7.40 | 2.98 |
| example 5 | 0.16 | 740 | 12.51 | 0.64 | 5.8 | 3.53 |
| example 6 | 0.21 | 770 | 12.46 | 0.58 | 5.6 | 3.62 |
| example 7 | 0.20 | 980 | 12.43 | 0.43 | 8.8 | 3.11 |
| example 8 | 0.28 | 1080 | 12.58 | 0.61 | 3.4 | 2.95 |
| example 9 | 0.23 | 2145 | 12.92 | 0.65 | 7.6 | 3.16 |

As can be seen from Table 3, in the powder X-ray diffraction spectrum (XRD) of the mono-crystalline cathode material for sodium-ion battery prepared in examples 1-8, the (110) diffraction peak having a diffraction angle 2 θ of around 64.9° has a full width at half maximum FWHM (110) of 0.15-0.27, a moisture mass content of 1200ppm or less, a pH of 12.60 or less, a specific surface area of 0.31-0.69$m^2/g$, a particle size $D_v50$ of 3.4-10.2 $\mu m$, and a powder compacted density of 2.95-3.83$g/cm^3$. Example 9 was not coated and had a moisture mass content of 2145ppm, much greater than 1500ppm, and a pH of 12.92, greater than 12.6.

**Experimental example 1**

Preparation and performance evaluation of sodium ion batteries.

CR2430 button cells were prepared as follows:

Positive preparation: the the mono-crystalline cathode material for sodium-ion battery prepared in examples 1-9 of the present invention were thoroughly mixed with an adhesive of polyvinylidene fluoride (PVDF) and conductive carbon black (S. P) in a weight ratio of 7: 2: 1, respectively, stirred to form a uniform slurry, coated on an aluminum foil current collector, dried and pressed to form pole pieces which is designated as PE-C1, PE-C2, PE-C3, PE-C4, PE-C5, PE-C6, PE-C7, PE-C8 and PE-C9.

Punching, weighing and baking were performed on the pressed positive sheet, and then the battery was assembled in a vacuum glove box. Firstly the shell bottom of the button cell was placed, and foamed nickel (2.5mm) and negative metal sodium sheet were placed on the shell bottom (manufacturer: Shenzhen Youyan Technology Co. Ltd.),

and 0.5g of an electrolyte was injected under an environment with a relative humidity of less than 1.5%, wherein the electrolyte was a mixed solvent of ethylene carbonate (EC), diethyl carbonate (DEC) and dimethyl carbonate (DMC) in a mass ratio of 1: 1: 1, and the electrolyte was a 1 mol/L sodium hexafluorophosphate solution. A separator and a positive sheet were placed. Secondly a shell cover of a button cell were covered and sealed, so as to obtain a button cell of type CR2430, which is denoted as BA-C1, BA-C2, BA-C3, BA-C4 and BA-C5, ba-C6, BA-C7, BA-C8 and BA-C9.

The performance test is performed on the battery test system according to the following method, and the results are shown in Table 4.

1) Capability test

The prepared button cell battery was attached to the test frame and the test procedure was started. Setup steps: setting the test temperature to 25°C, charging to 4.0V at a constant current of 0.1C after standing for 4 hours, suspending and standing, and then discharging to 2.0V at a constant current of 0.1C to obtain the capacity at this current and voltage.

2) Cycling test

The battery subjected to the capacity test was connected to the test rack, and the test procedure was started. Setup steps: setting the test teperature to 45°C, charging to 4.0V at a constant current of 0.5C after standing for 4 hours, turning to charge at a constant voltage of 4.0V for 2 hours, standing for 5 minutes, and then discharging at a constant current of 0.5C to a cut-off voltage of 2.0V, standing for 5 minutes. The previous steps of constant current charging were repeated to perform the cycling test. It can obtain the capacity retention rate with different cycle times.

Table 4 Test results of battery performance

| | cathode material | Capacity, (mAh/g) | Capacity retention rate |
|---|---|---|---|
| | | 4.2V-2.0V, 0.1C | 4.0 V-2.0V, 0.5C/0.5C after 50 cycles |
| BA-C1 | C1 | 132.0 | 88.00% |
| BA-C2 | C2 | 128.4 | 85.00% |
| BA-C3 | C3 | 130.1 | 86.40% |
| BA-C4 | C4 | 134.7 | 90.60% |
| BA-C5 | C5 | 136.3 | 91.5% |
| BA-C6 | C6 | 131.5 | 90.5% |
| BA-C7 | C7 | 164.0 | 80.2% |
| BA-C8 | C8 | 120.3 | 83.8% |
| BA-C9 | C9 | 130.5 | 74.84% |

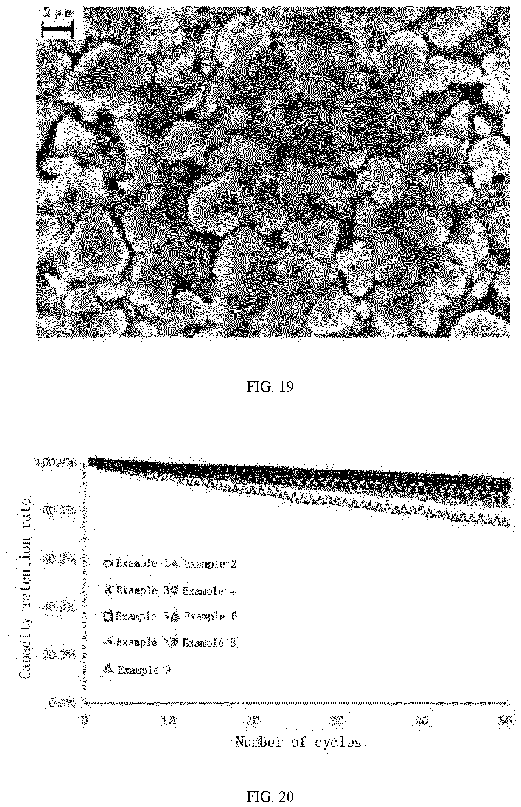

As can be seen from Table 4, the sodium ion batteries prepared using the mono-crystalline cathode material for sodium-ion battery prepared in examples 1-8 had capacities of 115.9-164.0 mAh/g at a current of 0.1C and a voltage of 4.2V (a cutoff voltage of 2.0V), and capacity retention rates of 80.2-90.5% after 50 cycles at 4.0V-2.0V and 0.5C/0.5C. example 9, without coating, had a capacity retention rate of only 74.84% after 50 cycles at 4.0V-2.0V, 0.5C/0.5C. As can also be seen from Fig. 20, the mono-crystalline cathode material for sodium-ion battery prepared in examples 1-8 exhibited significantly better capacity retention rate in cycling tests than that prepared in example 9.

After the cell BA-C1 was cycled for 50 times, the cell was disassembled to take the positive pole piece for SEM test. As shown in Fig. 19, it can be seen from Fig. 19 that the mono crystal particles after cycling were still intact particles without particle fragmentation.

What has been described above is merely a preferred embodiment of the invention and is not intended to limit the invention in any way. Thus, it is intended that the scope of protection of the present invention cover the modifications, equivalent replacement, and improvements made in the spirit and principle of the invention shall be included in the scope of protection of the invention..

**Claims**

1. A mono-crystalline cathode material for sodium-ion battery, **characterized in that** the mono-crystalline cathode material for sodium-ion battery, contains an element having a composition shown in chemical formula 1,

   the chemical formula 1 is $Na_{1+a}Ni_{1-x-y-z-c}Mn_xFe_yM_zN_cO_2$, wherein $-0.40 \leq a \leq 0.25$, $0.08 \leq x \leq 0.5$, $0.05 \leq y < 0.5$, $0 \leq z < 0.26$, $0 < c < 0.1$, M is a doping element, and N is a cladding element,
   the M and N is both one or a combination of two or more selected from the group consisting Ti, Zn, Co, Mn, Al, Zr, Y, Ca, Li, Rb, Cs, W, Ce, Mo, Ba, Mg, Ta, Nb, V, Sc, Sr, B, F, P or Cu elements.

2. The mono-crystalline cathode material for sodium-ion battery according to claim 1, wherein $-0.40 \leq a \leq 0$, $0.15 \leq x \leq 0.5$, $0.15 \leq y \leq 0.5$.

3. The mono-crystalline cathode material for sodium-ion battery according to claim 1 or 2, **characterized in that** the M is one or a combination of two or more selected from the group consisting Zn, Ti, Co, Al, Zr, Y, Ca, Li, Rb, Cs, W, Ce, Mo, Ba, Mg, Ta, Nb, V, Sc, Sr, B, F, P or Cu, preferably the M is one or a combination of two or more selected from the group consisting of Zn, Al, B, Ti, Ca, Y, Mg, Nb, Zr or Cu, more preferably the M is Zn; preferably, $0 \leq z \leq 0.13$, and/or the N is one or a combination of two or more selected from the group consisting of Al, Ti, Co, Mn, Y, B, F, P, Nb, Zr, W, Sr or Mg, preferably the N is one or a combination of two or more selected from the group consisting of Al, Ti, B, Nb or Mg; preferably, $0 < c < 0.05$.

4. The mono-crystalline cathode material for sodium-ion battery according to any one of claims 1 to 3, **characterized in that** a microscopic morphology of the mono-crystalline cathode material for sodium-ion battery under a scanning electron microscope is a mono crystal morphology; preferably, particles of the mono crystal morphology is one or a combination of two or more selected from the group consisting of spherical, spheroidal, polygonal or lamellar in shape.

5. The mono-crystalline cathode material for sodium-ion battery according to any one of claims 1 to 4, **characterized in that** the mono-crystalline cathode material for sodium-ion battery has a powder X-ray diffraction spectrum (XRD) in which a full width at half maximum (FWHM) (110) of a (110) diffraction peak having a diffraction angle $2\theta$ of around 64.9° ranges 0.08-0.35.

6. The mono-crystalline cathode material for sodium-ion battery according to any one of claims 1 to 5, **characterized in that** the mono-crystalline cathode material for sodium-ion battery has a powder compacted density of 2.8-4.2 $g/cm^3$ at a pressure of 7000-9000 kg,

   and/or the mono-crystalline cathode material for sodium-ion battery has a specific surface area of 0.35-1.2$m^2/g$, and/or the mono-crystalline cathode material for sodium-ion battery has a particle size $D_v50$ of 2.00-16.0$\mu$m, preferably 2.50-12.0$\mu$m.

7. The mono-crystalline cathode material for sodium-ion battery according to any one of claims 1 to 6, **characterized in that** the mono-crystalline cathode material for sodium-ion battery has a moisture mass content of less than 1500 ppm, preferably less than 1000 ppm, more preferably less than 900 ppm.

8. The mono-crystalline cathode material for sodium-ion battery according to any one of claims 1 to 7, **characterized in that** a pH of the mono-crystalline cathode material for sodium-ion battery is within 12.6.

9. A preparation method of the mono-crystalline cathode material for sodium-ion battery according to any one of claims 1 to 8, **characterized in that** it comprises the following steps:

   (1) mixing raw materials comprising a sodium source compound, a manganese source compound and an iron source compound, and adding a nickel source compound and an M source compound according to needs, then performing a first sintering and crushing to obtain a semi-finished product;
   (2) mixing the semi-finished product obtained in step (1) with an N source compound, then performing a second sintering and crushing to obtain the mono-crystalline cathode material for sodium-ion battery.

10. The preparation method according to claim 9 **characterized in that** a temperature of the first sintering in step (1) is 860-990°C, preferably 880-980°C; preferably, a constant temperature time is 6-40 hours,

and/or the crushing pressure in each of the step (1) and the step (2) is 0.1-1MPa,

and/or a temperature of the second sintering in step (2) is 350-900°C, preferably 350-800°C; preferably, a constant temperature time is 2-15 hours.

11. The preparation method according to claim 9 or 10, **characterized in that** the sodium source compound comprises a sodium element-containing salt and/or hydroxide; preferably, the sodium source compound is one or a combination of two or more selected from the group consisting of sodium carbonate, sodium formate, sodium hydroxide, sodium acetate, sodium chloride and sodium fluoride,

and/or the manganese source compound comprises one or a combination of two or more selected from the group consisting of an oxide, a hydroxide, or a salt containing a manganese element; preferably, the manganese source compound is one or a combination of two or more selected from the group consisting of manganese trioxide, manganese tetroxide, manganese oxide, manganese carbonate, manganese oxalate, manganese sulfate, manganese acetate, manganese chloride and manganese nitrate,

and/or the nickel source compound comprises one or a combination of two or more selected from the group consisting of an oxide, a hydroxide or a salt containing a nickel element; preferably, the nickel source compound is one or more selected from nickel carbonate, nickel oxalate, nickel sulfate, nickel acetate, nickel chloride and nickel nitrate,

and/or the iron source compound comprises one or a combination of two or more selected from the group consisting of oxides, hydroxides or salts containing an iron element; preferably, the iron source compound is one or a combination of two or more selected from the group consisting of ferric oxide, ferrous oxalate, ferrous sulfate, ferrous acetate and ferrous nitrate,

and/or the M source compound comprises an M element-containing oxide and/or salt; preferably, the M source compound comprises one or a combination of two or more selected from the group consisting of calcium oxide, calcium hydroxide, diboron trioxide, boric acid, niobium oxide, aluminum oxide, titanium oxide, magnesium oxide, copper oxide, yttrium trioxide, zirconium oxide, sodium fluoride, lithium fluoride, copper oxide, zinc oxide, and copper sulfate,

and/or the N source compound comprises an N element-containing oxide and/or salt; preferably, the N source compound comprises one or a combination of two or more selected from the group consisting of calcium oxide, boron trioxide, boric acid, niobium oxide, aluminum oxide, aluminum acetate, aluminum nitrate, titanium oxide, magnesium oxide, magnesium acetate, magnesium nitrate, copper oxide, yttrium trioxide, zirconium oxide, zirconium acetate, sodium fluoride, lithium fluoride, titanium dioxide, titanium oxide dispersion, zinc oxide, and copper sulfate.

12. A mono-crystalline cathode material for sodium-ion battery, **characterized by** being obtained by the preparation method according to any one of claims 9 to 11.

13. A positive electrode for a sodium ion battery, an active substance of which is the mono-crystalline cathode material for sodium-ion battery according to any one of claims 1 to 8 or claim 12.

14. A sodium ion battery, **characterized by** comprising the positive electrode for a sodium-ion battery of claim 13.

15. An application of the mono-crystalline cathode material for sodium-ion battery according to any one of claims 1-8 or claim 12, or the positive electrode for a sodium ion battery according to claim 13, or the sodium ion battery according to claim 14, in solar power generation, wind power generation, smart grids, distributed power stations, household energy storage batteries, low-end two-wheeled vehicle batteries or low energy density power batteries.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

EP 4 310 056 A1

FIG. 15

FIG. 16

25

FIG. 17

FIG. 18

FIG. 19

FIG. 20

Europäisches
Patentamt

European
Patent Office

Office européen
des brevets

# EUROPEAN SEARCH REPORT

Application Number

EP 23 18 5366

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 113 851 652 A (SVOLT ENERGY TECH CO LTD) 28 December 2021 (2021-12-28) | 1-4,6, 9-15 | INV. C01G53/00 H01M4/525 H01M10/054 |
| Y | * paragraphs [0015] - [0020]; claims; examples * | 1-15 | |
| X | CN 114 744 189 A (HUZHOU CHAONA NEW ENERGY TECH CO LTD) 12 July 2022 (2022-07-12) | 1-8, 12-15 | |
| A | * examples * | 9-11 | |
| Y | CN 109 817 970 A (SHANGHAI ZIJIAN CHEMICAL TECH CO LTD) 28 May 2019 (2019-05-28) | 1-15 | |
|   | * examples * | | |

TECHNICAL FIELDS
SEARCHED        (IPC)

C01G
H01M

The present search report has been drawn up for all claims

| Place of search | Date of completion of the search | Examiner |
|---|---|---|
| Munich | 8 December 2023 | Marucci, Alessandra |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 18 5366

This annex lists the patent family members relating to the patent documents cited in the above-mentioned European search report.
The members are as contained in the European Patent Office EDP file on
The European Patent Office is in no way liable for these particulars which are merely given for the purpose of information.

08-12-2023

| Patent document cited in search report | | Publication date | Patent family member(s) | Publication date |
|---|---|---|---|---|
| CN 113851652 | A | 28-12-2021 | NONE | |
| CN 114744189 | A | 12-07-2022 | NONE | |
| CN 109817970 | A | 28-05-2019 | NONE | |

EPO FORM P0459

For more details about this annex : see Official Journal of the European Patent Office, No. 12/82

**EP 4 310 056 A1**

**REFERENCES CITED IN THE DESCRIPTION**

**Patent documents cited in the description**

- GB T195872006 A
- GB T190772016 A
- GB T111332015 A